Europäisches Patentamt

European Patent Office

Office européen des brevets

(11) Publication number: **0 342 531**
**A2**

## (12) EUROPEAN PATENT APPLICATION

(21) Application number: **89108531.8**

(22) Date of filing: **11.05.89**

(51) Int. Cl.4: **G11C 5/00**

(30) Priority: **20.05.88 JP 66642/88**

(43) Date of publication of application:
**23.11.89 Bulletin 89/47**

(84) Designated Contracting States:
**DE FR GB**

(71) Applicant: **MITSUBISHI PETROCHEMICAL CO., LTD.**
**5-2, 2-chome, Marunouchi**
**Chiyoda-ku Tokyo 100(JP)**

(72) Inventor: **Miyabayashi, Mitsutaka Advanced Material Lab.**
**Mitsubishi Petrochemical Co. Ltd. 1, Toho-cho**
**Yokkaichi Mie ken(JP)**
Inventor: **Kurihara, Hiroshi Electronic Products Dev. Center**
**Mitsubishi Petrochemical Co. Ltd.**
**Takaramachi 3-1**
**Hiratsukashi Kanagawa ken(JP)**
Inventor: **Hashizume, Nichio Electronic Products Dev. Center**
**Mitsubishi Petrochemical Co. Ltd.**
**Takaramachi 3-1**
**Hiratsukashi Kanagawa ken(JP)**

(74) Representative: **Walter, Helmut**
**Aubingerstrasse 81**
**D-8000 München 60(DE)**

(54) **Memory back up system.**

㉗ A memory back up system comprising a charging circuit (1) inputing a DC voltage (Vi), a secondary battery (2) being charged by a charging voltage, a diode ($D_1$) for supplying the voltage of the secondary battery (2) to a memory (M) when said DC input voltage (Vi) falls below a predetermined value and a feed back preventing circuit (3) for preventing current supplied to the memory (M) from feeding back to the electric source.

## MEMORY BACK UP SYSTEM

### Field of the Invention

This invention relates to a memory back up system for a computer in which a DC voltage source for supplying electric power to the memory of the computer always charges a small secondary battery which supplies voltage to the memory at an accident such as power cut for holding the memory and protects the memory.

### Background of the Invention

A lithium secondary battery has been developed for its high electromotive force, high energy density and the excellent character of its charge/discharge cycle, and recently this excellent lithium battery has been utilized.

On the other hand, a memory in the memory circuit of a micro processor system is held by the back up of an electric source of battery during loss of power. It is preferable to use a secondary battery for to back up an electric source because it is a maintenance free electric source.

For example, a 2.5 volt electric source is required to back up S-RAM and, in the case of nickel cadmium battery, needs 2 - 3 batteries. However, in the case of a lithium battery, only one is required to obtain the voltage and it is available at a lower cost.

In an electronic machine, it is usual to use a 5 - 12 volt electric source, and charging a secondary battery is possible by this voltage. But if a lithium battery is charged by more than a 4 volt source, the electrolyte solution in the battery is decomposed and generates a gas that lowers its ability. Therefore, it is desired to charge the lithium battery by a source less of than 3.5 volt. It is required a charging circuit including a constant voltage regulated power supply for charging the lithium battery less than 3.5 volt using a 5 - 12 volt electric source.

Current consumed in S-RAM memory at back up is a few $\mu A$. Accordingly, it is desired that the inner current consumed in the memory at back up including said charging circuit is a small current of less than a few $\mu A$, and for this, a suitable circuit design is required.

Heretofore, in a back up circuit for a lithium battery, a DC voltage Vi is divided into a charging voltage Vz for charging the secondary battery by a series circuit of a resistor and a zener diode and at power cut, the secondary battery discharges the charged electricity through said dividing resistor to the memory. However, prior circuits have many parts, complicate the assembling of connecting many parts, and at power cut, leakage of the current from the secondary battery is large because the secondary battery discharges the charged electricity through said dividing resistor to the memory so that the efficiency is not good.

This invention eliminates said drawbacks and provides a suitable charging circuit for a lithium battery.

An object of this invention is to provide a memory back up system in which the charging circuit 1 charges the secondary battery 2 by a charging voltage Vz through diode $D_2$ and holds the memory by voltage $V_0$ from feed back preventing circuit 3 when the voltage Vi is in the range of normal voltage.

Another object of this invention is to provide a memory back up system in which the charging circuit stops charging and the charged secondary battery 2 supplies a voltage through diode $D_1$ to memory M and can hold the memory when the voltage Vi is under the range of normal voltage or during a power cut. In this case, the feed back preventing circuit 3 prevents the feed back of current supplied to the memory to the DC voltage cource.

Another object of this invention is to provide a memory back up system in which a reset signal from the reset circuit inhibits the writing action of the memory M by backing up the memory protect logic circuit 5 and holds the memory for a predetermined interval and prevents the confusion of memory when the electric source voltage Vi is resumed in the range of normal voltage.

Still another object of this invention is to provide a memory back up system in which the charging circuit 1 is connected to the feed back preventing circuit 3 through forward diodes $D_1$, $D_2$, electric power of the secondary battery 2 is only fed to the memory M and is never fed to the other and thus prevents loss of electric power.

### Brief Description of the invention

This invention comprises a charging circuit 1 inputing DC voltage Vi and outputs voltage Vz for charging, a small secondary battery 2 normally charged by charging voltage Vz, a feed back preventing circuit 3 for preventing the feed back of current supplied to the memory M by the electric source, and a diode $D_1$ for supplying the voltage of the secondary battery 2 to memory M when said DC voltage Vi is lower than a predetermined value.

Said battery 2 may be a lithium secondary battery.

Said DC voltage Vi is divided by a series circuit of a resistor $R_5$ and a zener diode $Dz_2$.

The above and other features of this invention will be more fully understood from the following detailed description and the accompanying drawings, in which;

## Brief Description of the Drawings

Fig 1 is a block diagram of a memory back up circuit of one embodiment of this invention.

Fig 2 is a circuit network of the embodiment of this invention.

Figs 3, a, b, are a perspective view of a package for the back up circuit and a cross sectional view respectively of the embodiment of this invention.

Fig 4 shows a circuit network of a memory back up circuit of another embodiment of this invention.

## Detailed Description of the Invention

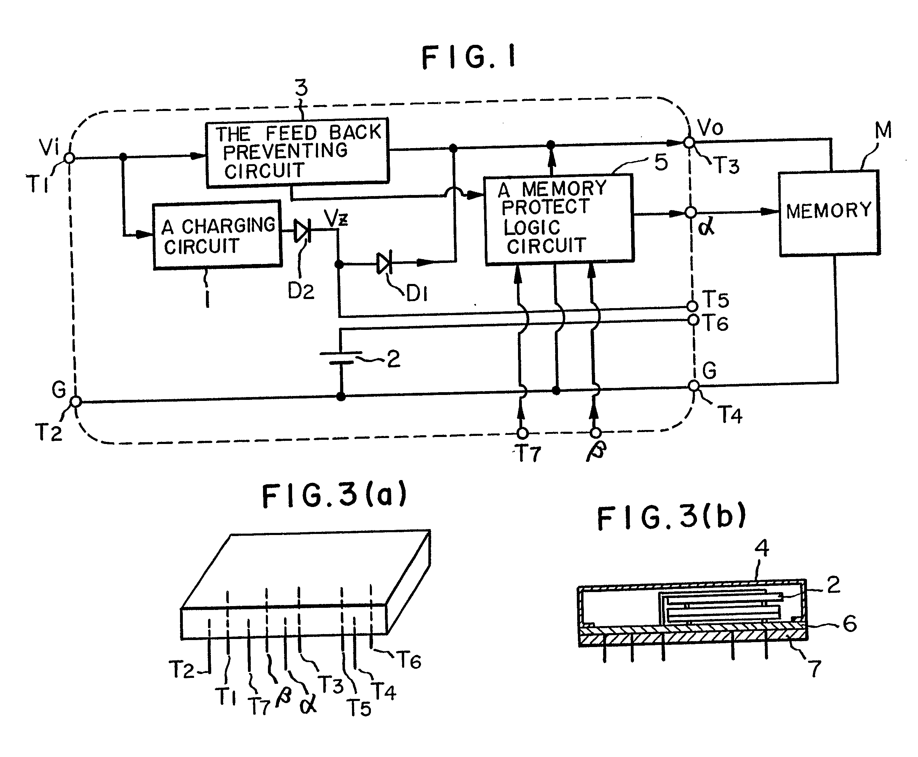

In Fig. 1. Vi is a DC voltage converted from AC voltage, and the DC voltage Vi is input to a feed back preventing circuit 3. The feed back preventing circuit 3 detects the drop of the DC voltage Vi below a predetermined value and prevents reverse current.

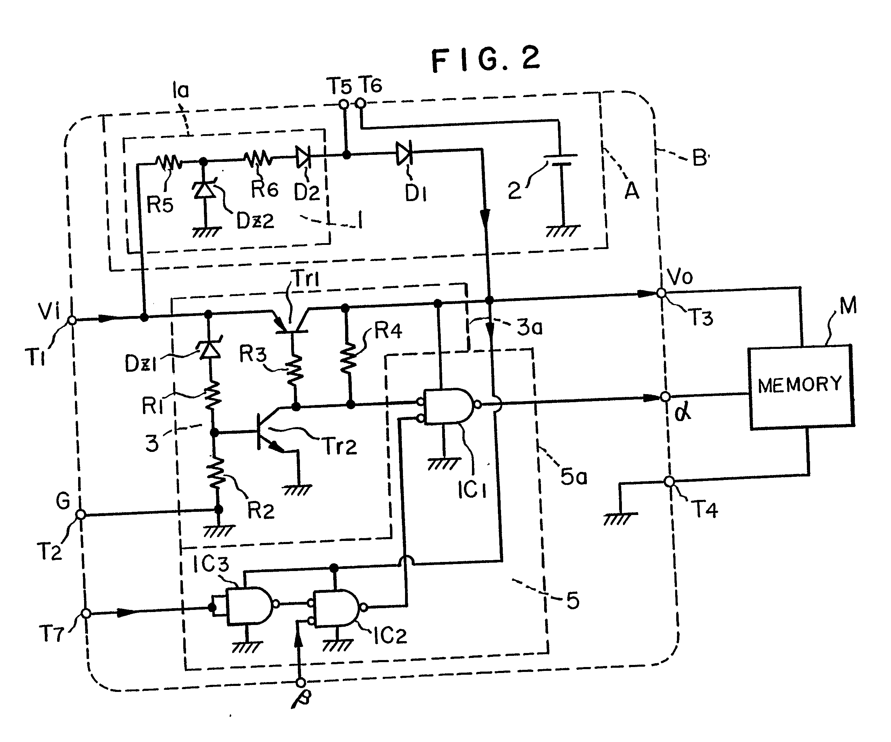

The feed back preventing circuit 3, for example as shown in the area of broken line 3a of Fig 2, comprises a PNP transistor $Tr_1$ whose emitter and collector are interposed between input terminal $T_1$ of said voltage Vi and output lead terminal $T_3$. PNP transistor $Tr_2$ controls the transistor $Tr_1$. A series circuit of zener diode $Dz_1$ and resistor $R_1$ is connected between terminal $T_1$ and the base of the transistor $Tr_2$. The base and the emitter of transistor $Tr_2$ are connected by a resistor $R_2$ and the emitter of the transistor $Tr_2$ is connected to earth ground. The base of the transistor $Tr_1$ and collector of the transistor $Tr_2$ are connected by a resistor $R_3$. The collector of the transistor $Tr_1$, connected to a terminal $T_3$ of $V_0$ voltage, and the collector of the transistor $Tr_2$ are connected by a resistor $R_4$.

Charging circuit 1 receives input DC voltage Vi and outputs a voltage Vz through a diode $D_2$. As shown by broken line 1a in Fig 2, charging circuit 1 comprises a series circuit of a resistor $R_5$ connected to said transistor $Tr_1$ and a zener diode $Dz_2$ connected to earth ground. A resistor $R_6$ is connected to the junction between said resistor $R_5$ and the zener diode $Dz_2$.

Secondary battery 2 may be a lithium battery. The lithium battery has lithium metal or its alloy as a negative pole and the alloy is Li x M ( where x means the molar fraction against metal M ). M is a metal such as aluminium (Al), lead (Pb), zinc (Zn), tin (Sn), bismuth (Bi), indium (In), magnesium (Mg), gallium (Ga), cadmium (Cd), silver (Ag), silicon (Si), boron (B), platinum (Pt), palladium (Pd), antimony (Sb) and (Al), (Pb). In are preferable and Al is the most preferable.

It is possible to use carbonaceous materials having lithium as active material, and said carbonaceous materials are preferably imitation graphite constitution materials obtained from a calcined organic compound having following character;

a) an atom ratio of hydrogen / carbon of less than 0.15.

b) carbon material whose face distance (d 00z) of (002) face by X-ray diffraction wide angle topography is more than 3.37Å and magnitude (Lc) of crystal in the c crystallographic axis is less than 150Å. The material of the positive pole is a metal chalcogen compound such as vanadium oxide, vanadium sulfide, molybdenum oxide, molybdenum sulfide, manganese oxide, chromium oxide, titanium oxide, titanium sulfide, and their composite oxides and composite sulfides. Materials such as $Cr_3O_8$, $V_2O_5$, $V_5O_{13}$, $VO_2$, $Cr_2O_5$, $MnO_2$, $TiO_2$, $MoV_2O_8$, $TiS_2$, $V_2S_5$, $MoS_2$, $MoS_3$, $VS_2$, $Cr_{0.25}V_{0.75}S_2$, $Cr_{0.5}V_{0.75}S_2$ etc are preferable. An oxide such as $LiCoO_2$, $WO_3$ etc, a sulfide such as $CuS$, $Fe_{0.25}V_{0.75}S_2$, $Na_{0.1}CrS_2$ etc, phosphuretted or a sulfide such as $NiPS_3$, $FePS_3$, selenide such as $VSe_2$, $NbSe_3$ can be used.

A separator for reserving electrolyte consists of a material comprising liquid, for example, a non-woven fabric of polyolefine resin. The separator is comprised of a non electrolyte solution which resolves electrolyte such as $LiClO_4$, $LiBF_4$, $LiAsF_5$, $LiPF_6$ into non-proton organic solution such as propylene carbonate, 1,3-dioxolane, 1,2-dimethoxyethane etc.

It is possible to interpose a solid electrolyte which is a conductor of (Li) or alkali metal ion between the positive pole and negative pole.

A secondary battery 2 is connected between the cathode of the diode $D_2$ and earth.

The back up circuit of this invention surrounded by dotted line A in Fig 2 is preferably a module unit as a package.

If the back up circuit is to be packaged, the secondary battery is dis-connected from the diode $D_2$ before installation into a computer to prevent discharge of current, and terminals $T_5$, $T_6$ are connected after the package is installed in the computer.

Memory protect logic circuit 5 is for generating a signal $\alpha$ to inhibit memory operation of memory M to protect the memory due to an abnormal source signal, for example, a HALT signal of the computer, an abnormal signal of a source monitoring circuit or a reset signal.

Memory protect logic circuit 5 of Fig 2 is shown by broken line 5a is operated by the reset signal. A reset circuit (not shown) generates the reset signal input to the terminal $T_7$ when the electric source turns from OFF to ON and a central processing unit (CPU) turns on the initial condition and to set and initiate execution of a program. The logic circuit 5a (Fig 2) comprises logic (inverter) $IC_1$, $IC_2$ and $IC_3$. When the reset signal is high, logic $IC_3$ generates H (high) level signal. Logic $IC_2$ receives the output of the logic $IC_3$ and the chip select signal $\beta$. Logic $IC_1$ receives H level signal of the logic $IC_2$ and H level signal of said feed back preventing circuit 3 and generates a high level chip select signal $\alpha$ which is fed to memory M.

Every circuit of charging circuit 1, secondary battery 2, diode $D_1$, $D_2$, feed back preventing circuit 3, memory protect logic circuit 5, surrounded by dotted line B, can be a module and constructed in a package. For configuring the package, circuits such as charging circuit 1 etc, are provided on a base plate having pins in a predetermined position. The secondary battery 2 having a terminal is laminated on the base plate and soldered. Then the base plate and the secondary battery 2 are sealed by resin by following steps.

For example, the base plate is covered by a outer plastic can moulded from ABS, PET or a polycarbonate thermoplastic resin. Then a thermosetting resin chiefly consisting of epoxy resin fills the can from the base plate side and cured.

For sealing, it is possible to dip the base plate into the thermosetting resin.

It is preferable to include a nonconbustible material such as a halide into said thermoplastic resin of the can or thermosetting resin.

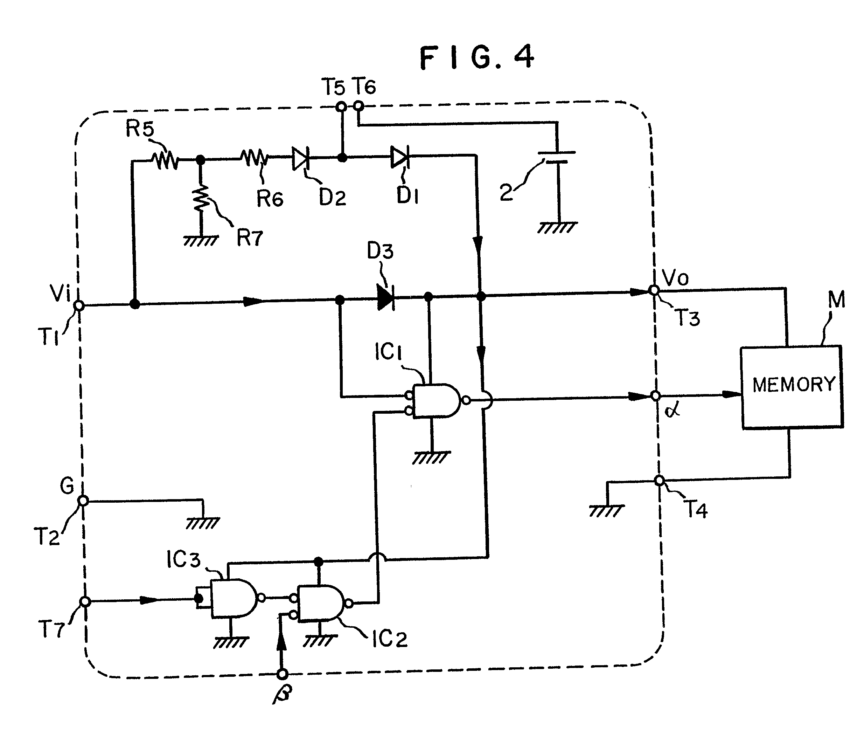

Fig 3, a, b, show a perspective view of a package for the back up circuit and a cross sectional view of an embodiment of this invention. The pakage has a case 4, a moulding material 6, such as epoxy resin, a base plate 7 which has input terminal $T_1$, input earth terminal $T_2$, output terminal $T_3$, output earth terminal $T_4$, terminal $T_5$, battery connecting terminal $T_6$, reset terminal $T_7$, chip select terminal CS($\beta$), and ram chip select terminal $\alpha$.

Operation of said device is as follows;

When the voltage Vi is in the range of normal voltage, electric current flows from DC voltage Vi through diode $D_1$, zener diode $Dz_1$ and resistors $R_1$, $R_2$. A voltage produced in the resistor $R_2$ causes current flow to the base and the emitter of the NPN transistor $Tr_2$, thus the base conducts and a signal is emitted. By this conduction, emitter and base of transistor $Tr_1$, resistor $R_3$, collector and emitter of transistor $Tr_2$, thus collector and emitter of transistor $Tr_1$ conducts. On the other hand, current flows from DC voltage source Vi through resistor $R_5$, zener diode $Dz_2$, the zener voltage Vz causes current to flow through resistor $R_6$, and diode $D_2$, to secondary battery 2 and the battery is always charged and an output voltage $V_0$ holds the memory in memory M.

In this case, a L (low) level signal is input from the collector of transistor $Tr_2$ to one input terminal of logic $LC_1$. An H (high) level signal is input from reset terminal $T_7$ to logic $IC_3$ and logic $IC_3$ outputs L signal to logic $IC_2$. One terminal of the logic $IC_2$ receives this L level signal and other terminal of the logic $IC_2$ receives L level signal from chip select terminal $\beta$ and logic $IC_2$ outputs L level signal to logic $IC_1$. As the result, output of the logic $IC_1$ is an L level signal and memory M can perform a normal writing action.

When the voltage Vi is under the range of a normal voltage or power is lost, the voltage produced in the resistor $R_2$ drops and conduction between the base and the emitter of the NPN transistor $Tr_2$ is cut, thus the voltage of the base of transistor $Tr_1$ rises, conduction between collector and emitter of transistor $Tr_1$ stops and the charging circuit 1 becomes inactive. The charged secondary battery 2 supplies voltage through diode $D_1$ to memory M and holds the memory.

In this case, an H level signal is input from the collector of transistor $Tr_2$ to one input terminal of logic $LC_1$. An H (high) level signal is input from logic $IC_1$ to the chip select terminal of the memory M and memory M inhibits writing actions and protects its memory and holds it.

When the voltage Vi resumes in the range of a normal voltage and until the central processing unit operates normally, an L level signal is fed from reset terminal $T_7$ to the logic $IC_3$ and the logic $IC_3$ generates an H level signal and an feeds it to one terminal of the logic $IC_2$. The other terminal of the logic $IC_2$ receives an L level signal from the chip select terminal $\beta$ and generates an H level signal. Logic $IC_1$ receives the H level signal from the logic $IC_2$ and generates an H level signal to the chip select of the memory M and inhibits writing actions of the memory M and holds the memory.

After a predetermined interval, reset terminal $T_7$ changed to an H level signal and the output of the logic $IC_1$ becomes an L level signal and resumes writing actions.

The charging circuit 1 is connected to the feed back preventing circuit 3 through foward diodes $D_1$, $D_2$, and electric power of the secondary battery 2 is only fed to the memory M and never fed to the other circuits and prevents loss of electric power.

In other words, current never flows from the secondary battery 2 to diode $D_2$, resistor $R_6$, zener diode $Dz_2$, NPN transistors $Tr_1$, $Tr_2$ of the feed

back preventing circuit 3 are OFF so that the charging circuit 1 and the feed back preventing circuit 3 do not consume electric power.

As shown in Fig 4, in the feed back preventing circuit 3, a diode $D_3$ is provided instead of transistors $Tr_1$, $Tr_2$ and back up current of the secondary battery 2 never flows into DC voltage Vi.

In charging circuit 1, two resistors $R_5$,$R_7$ are possible instead of resistor $R_5$, and zener diode $Dz_2$.

As explained above, in this invention, when the voltage Vi is under the range of a normal voltage at power loss, the charged secondary battery 2 supplies voltage through diode $D_1$ to memory M and can hold the memory. And in this case, a protecting signal for the memory M is generated, and inhibits writing actions in the memory M and protects its memory and holds it. When the voltage Vi is resumed in the range of a normal voltage, reset signal from the reset circuit inhibits writing actions of the memory M by backing up the memory protect logic circuit 5 and holds the memory for a predetermined interval and prevents the confusion in the memory when the electric souce is resumed. And as the charging circuit 1 is connected to the feed back preventing circuit 3 through foword diodes $D_1$,$D_2$, electric power of the secondary battery 2 is only fed to the memory M and not fed to the other circuits and prevents loss of electric power.

## Claims

1. A memory back up system comprising; a charging circuit (1) receiving a DC voltage (Vi) input divided by a circuit consisting of a resistor ($R_5$) and zener diode ($Dz_2$) or resistors ($R_5$, $R_7$) to obtain an output charging voltage (Vz) and a secondary battery (2) normally charged by said charging voltage (Vz), a diode ($D_1$) for supplying the voltage of said secondary battery(2) to a memory (M) when said DC input voltage Vi is lowered below a predetermined value and a feed back preventing circuit (3) for preventing current supplied to the memory (M) from feeding back to the electric source.

2. A memory back up system as claimed in claim 1 in which said battery (2) is a lithium secondary battery.

3. A memory back up system as claimed in claim 1 in which said DC input voltage (Vi) is divided by a series circuit of a resistor ($R_5$) and a zener diode ($Dz_2$) for feeding charging voltage (Vz).

4. A memory back up system as claimed in claim 1 in which said feed back preventing circuit (3) comprises; an NPN transistor ($Tr_1$) whose emit-

ter and collector are interposed between an input terminal for said DC voltage (Vi), a series circuit of a zener diode ($Dz_1$), and resistors ($R_1$ and $R_1$) connected between said input terminal ($T_1$) of said DC voltage (Vi), and the base of a secondary transistor ($Tr_2$) for controlling said NPN transistor ($Tr_1$) connected to the junction between said resistors ($R_1$ and $R_2$), the emitter of said secondary transistor ($Tr_2$) being connected to ground, the collector of the secondary transistor ($Tr_2$) being connected to the base of said NPN transistor ($Tr_1$) through a resistor ($R_3$) and being connected to the collector of said NPN transistor ($Tr_1$) through another resistor ($R_4$).

5. A secondary battery package having a charging function which includes a charging circuit (1) inputting a charging voltage (Vz) through diode ($D_2$), a small secondary battery (2) being continuously charged by said charging voltage (Vz), a diode ($D_1$) for feeding the voltage of said secondary battery (2) to a memory (M) when a DC input voltage (Vi) falls below a predetermined value and a memory protect logic circuit (5) for inhibiting the writing actions to the memory (M) and protecting the memory when said DC input voltage (Vi) falls below a predetermined value and inhibiting writing actions to the memory (M) for a predetermined interval due to a reset signal from a reset circuit when said DC input voltage (Vi) returns to a normal voltage range.

# FIG. 1

THE FEED BACK PREVENTING CIRCUIT

A CHARGING CIRCUIT

A MEMORY PROTECT LOGIC CIRCUIT

MEMORY

# FIG. 3(a)

# FIG. 3(b)

EP 0 342 531 A2

FIG. 2

FIG. 4